# FASCICULE DE BREVET EUROPEEN

(11) **EP 4 127 262 B1**
(45) Date de publication et mention de la délivrance du brevet: **24.04.2024**
(21) Numéro de dépôt: 21716505.9
(22) Date de dépôt: 19.03.2021
(51) Int. Cl.: C23C 16/04, C23C 16/26, C23C 16/455, C23C 16/44, B01D 53/00, B01D 53/72, C01B 3/50, C04B 35/83, B01D 53/24

(54) **PROCÉDÉ DE DENSIFICATION DE MATÉRIAUX COMPOSITES**
VERFAHREN ZUM VERDICHTEN VON VERBUNDWERKSTOFFEN
METHOD FOR DENSIFYING COMPOSITE MATERIALS

(30) Priorité: 30.03.2020 FR 2003120
(43) Date de publication de la demande: 08.02.2023
(73) Titulaire: Safran Ceramics, 33185 Le Haillan (FR)
(72) Inventeur: POTIN, Jean-François Daniel René, 77550 Moissy-Cramayel (FR); DELEHOUZE, Arnaud, 77550 Moissy-Cramayel (FR); GOUJARD, Stéphane Roger André, 77550 Moissy-Cramayel (FR)
(74) Mandataire: Cabinet Beau de Loménie
(86) Numéro de dépôt international: PCT/FR2021/050463
(87) Numéro de publication internationale: WO 2021/198582

(56) Documents cités:
- WO-A1-2006/077353
- FR-B1- 2 881 145
- US-A1- 2006 029 804

## Description

### Domaine Technique

L'invention s'inscrit dans le domaine de la densification de structures poreuses par infiltration chimique en phase vapeur et aux installations pour réaliser une telle densification. Elle apporte un perfectionnement à cette technique de densification telle qu'envisagée dans l'art antérieur.

### Technique antérieure

La densification de substrats poreux par infiltration chimique en phase vapeur est connue. Dans les procédés utilisés, les substrats sont placés dans un four, puis le four est alimenté en une phase gazeuse réactive, permettant, de former la matrice dans les porosités des substrats. Le choix du gaz constituant la phase gazeuse et les conditions de température et de pression régnant dans le four déterminent la nature de la matrice formée. Dans le cas de la formation de matrice de carbone pyrogéné, il est généralement utilisé à titre de phase gazeuse réactive des hydrocarbures linéaires de faible longueur.

Le coût du procédé est directement impacté par la nature choisie pour la phase gazeuse réactive. De manière générale, le coût est d'autant plus élevé que la phase gazeuse réactive est riche en atomes de carbone.

Au cours d'un procédé de densification d'une structure poreuse, seule une partie de la phase gazeuse réactive réagit effectivement au contact de la préforme pour déposer du pyrocarbone. Les effluents gazeux récupérés en sortie du four de densification sont composés d'espèces présentes initialement dans la phase gazeuse réactive n'ayant pas réagies et également de produits des réactions des espèces de la phase gazeuse réactive entre elles. Parmi les produits de réaction des espèces de la phase gazeuse réactive entre elles, on trouve entre autres des hydrocarbures aromatiques et des hydrocarbures polyaromatiques.

Il a été proposé, comme par exemple dans WO 2006/077353 de séparer les espèces présentes initialement dans la phase gazeuse réactive n'ayant pas réagi des effluents gazeux pour les réintroduire avec la phase gazeuse réactive en entrée du four de densification.

Un tel recyclage permet de diminuer la quantité de phase gazeuse réactive nouvelle introduite, et ainsi de réaliser des économies.

Toutefois, les hydrocarbures polyaromatiques récupérés en sortie du four de densification ne sont pas valorisés dans les procédés de l'art antérieur.

Il demeure un besoin pour l'amélioration des procédés de densification existants et notamment pour remédier aux désavantages précités.

### Exposé de l'invention

L'invention vise précisément à satisfaire à ce besoin et pour cela propose un procédé de densification d'un ou plusieurs substrats poreux par du carbone pyrolytique par infiltration chimique en phase vapeur comprenant au moins les étapes suivantes :
- l'admission en entrée du four de densification d'une phase gazeuse réactive comprenant au moins un précurseur de carbone pyrolytique ;
- la réaction d'au moins une fraction de la phase gazeuse réactive avec le ou les substrats poreux ;
- l'extraction en sortie du four de densification des effluents gazeux issus de la phase gazeuse réactive;
- la réintroduction avec la phase gazeuse réactive admise en entrée du four de densification d'au moins une fraction des effluents gazeux extraits en sortie du four ; caractérisé en ce que la fraction des effluents gazeux introduits avec la phase gazeuse réactive comprend au moins un composé hydrocarbure polyaromatique.

Un procédé tel que décrit ci-dessus permet de s'affranchir des désavantages des procédés de l'art antérieur, de diminuer les coûts et également de réduire les quantités de déchets générés par un procédé, une partie d'entre eux pouvant être réutilisés.

Par « composé hydrocarbure polyaromatique » il est entendu une espèce chimique composée de carbone et d'hydrogène présentant plus d'un cycle aromatique.

Par exemple de tels composés hydrocarbures polyaromatiques convenant à l'invention peuvent être choisis parmi le napthalène, l'acénaphthylène, l'acénaphthène, le fluorène, le phénanthrène, l'anthracène, le fluoranthène, le pyrène, le dibenzyl-toluène et leurs mélanges.

Les inventeurs ont constatés que la présence d'un composé hydrocarbure polyaromatique avec la phase gazeuse réactive permet la densification des substrats, même lorsque moins de phase gazeuse réactive est introduite dans le four de densification que dans les procédés de l'art antérieur. En d'autres termes, l'introduction d'hydrocarbures polyaromatiques dans le four de densification avec la phase gazeuse réactive permet de réduire la quantité de phase gazeuse réactive nécessaire à la densification des substrats, et permet par conséquent de diminuer le coût du procédé. La diminution de la phase gazeuse réactive est permise par la très riche teneur en carbone des hydrocarbures polyaromatiques introduits avec la phase gazeuse réactive. Ainsi, la quantité d'hydrocarbures polyaromatiques introduite avec la phase réactive permet d'apporter le carbone équivalent à une partie de la phase gazeuse réactive qui peut ainsi être économisée.

De plus, un procédé tel que décrit ci-dessus permet une réutilisation des hydrocarbures polyaromatiques sans nécessiter aucune transformation préalable de ces derniers qui sont réintroduits dans le four avec la phase réactive.

De préférence, la quantité d'hydrocarbures polyaromatiques introduite dans le four de densification avec la phase gazeuse réactive est relativement faible pour éviter tout encrassement des conduits d'injection, et le cas échéant, de la chambre de préchauffage. Par exemple, la quantité d'hydrocarbure polyaromatique introduite peut être comprise entre 0,5 % et 5,0 % en poids d'hydrocarbures polyaromatiques par rapport au poids de la phase gazeuse réactive. De préférence, la quantité d'hydrocarbures polyaromatiques introduite peut être comprise entre 0,9 % et 1,1 % en poids d'hydrocarbures polyaromatiques par rapport au poids de la phase gazeuse.

Dans un mode de réalisation, le rapport massique entre les efluents gazeux réintroduits et la phase gazeuse est compris entre 0,5 % et 5,0 %.

Dans un mode de réalisation, la quantité d'hydrocarbures polyaromatiques introduite avec la phase gazeuse réactive varie au cours de l'avancement de la densification des substrats poreux.

Il a en effet été constaté qu'une teneur en composés hydrocarbures polyaromatiques élevée en début de densification permet une meilleure densification des substrats, tandis qu'en fin de densification, le débit d'hydrocarbures polyaromatiques peut être diminué ou même arrêté pour éviter la formation de suie sur les pièces à densifier. Dans un mode de réalisation, le débit d'hydrocarbures polyaromatiques peut être nul en fin de procédé.

Par exemple, la quantité d'hydrocarbures polyaromatiques introduite avec la phase gazeuse réactive peut varier de 5,0 % à 0,0 % massique par rapport à la phase gazeuse réactive entre le début et la fin du procédé de densification.

Dans un mode de réalisation, la quantité d'hydrocarbures polyaromatiques introduite en début d'infiltration est comprise entre 0,5 % et 1,0 % massique par rapport au poids de la phase gazeuse réactive au début du procédé, puis est diminuée progressivement jusqu'à être nulle en fin du procédé. Dans un mode de réalisation préféré, la quantité d'hydrocarbures polyaromatiques introduite est diminuée progressivement jusqu'à être nulle à environ la moitié de la durée du procédé.

Les inventeurs ont constatés que la diminution progressive de la quantité d'hydrocarbures polyaromatiques introduite au cours du procédé permet d'une part d'augmenter le taux de carbone présent dans le four au début du procédé et d'autre part d'éviter le dépôt de suies en fin de procédé, quand la densification des substrats est déjà avancée et qu'il n'est plus nécessaire d'introduire une quantité importante de carbone dans le four.

Par « phase gazeuse réactive », il est entendu les espèces génératrices de pyrocarbone introduite sous forme gazeuse dans le four de densification. Dans un mode de réalisation de l'invention, un gaz vecteur peut être présent pour transporter la phase gazeuse réactive et la fraction d'hydrocarbures polyaromatiques injectée dans le four, avant introduction dans le four de densification. Un tel gaz vecteur s'il ne prend pas part à la réaction de densification ne fait pas partie de la « phase gazeuse réactive » au sens de l'invention.

Le gaz vecteur peut être choisi parmi un gaz neutre, par exemple du diazote ou de l'hydrogène, un gaz participant à la réaction de densification, par exemple un hydrocarbure à moins de quatre atomes de carbone, ou un mélange de deux ou plus de ces gaz.

Dans un mode de réalisation de l'invention, le procédé comprend en outre une étape de séparation des composés des effluents gazeux extraits en sortie du four qui peut être réalisée par centrifugation, par filtration mécanique, par précipitation, par décantation ou par une combinaison de ces méthodes.

Au cours d'une telle étape, les hydrocarbures polyaromatiques sont séparés des effluents gazeux obtenus en sortie du four de densification pour permettre leur réinjection avec la phase gazeuse réactive.

Les inventeurs ont constatés que l'introduction avec la phase gazeuse réactive d'une partie des effluents gazeux comprenant au moins un composé hydrocarbure polyaromatique permet la densification de substrats par du carbone pyrolytique avec une phase gazeuse réactive plus pauvre en carbone que dans les procédés de l'art antérieur. Il en résulte un procédé au coût diminué comparativement aux procédés utilisant des phases gazeuses réactives composées de précurseurs de carbone pyrolytiques ayant des chaînes carbonées plus longues.

Ainsi, dans un mode de réalisation, la phase gazeuse réactive peut être composée d'alcanes ayant jusqu'à 4 atomes de carbone et de préférence jusqu'à 3 atomes de carbone. En d'autres termes, la phase gazeuse réactive peut comprendre du méthane, de l'éthane, du propane, du butane, des isomères du butane ou un mélange de ces composés. De préférence, la phase gazeuse réactive peut comprendre du méthane, de l'éthane et/ou du propane.

Limiter la phase gazeuse réactive à des alcanes linéaires de faible longueur de chaîne permet d'en diminuer le coût comparativement à des phases gazeuses composées d'alcanes de chaînes plus longues utilisées dans les procédés de l'art antérieur.

Dans un mode de réalisation, le procédé comprend une étape de dissolution des hydrocarbures polyaromatiques dans un solvant. Par exemple, le solvant utilisé pour dissoudre les hydrocarbures polyaromatiques peut être du dibenzyl-toluène.

En d'autres termes, la fraction des effluents gazeux introduite avec la phase réactive peut être mélangée avec la phase gazeuse réactive avant son introduction dans le four de densification.

Dans un mode de réalisation, le procédé comprend en outre une étape de mélange de la phase gazeuse réactive avec la fraction des effluents gazeux comprenant au moins un composé hydrocarbure polyaromatique avant l'admission de la phase gazeuse réactive dans le four de densification. Le mélange des hydrocarbures polyaromatiques avec la phase gazeuse réactive permet d'éviter toute recondensation des hydrocarbures polyaromatiques et ainsi d'éviter tout encrassement du four de densification. De plus, ce mélange, réalisé avant l'introduction dans le four de densification, permet une meilleure homogénéité des hydrocarbures polyaromatiques dans la phase gazeuse réactive introduite dans le réacteur, et enfin une diminution de la quantité de gaz vecteur nécessaire.

Dans un mode de réalisation, le ou les substrats poreux sont des préformes de freins carbone.

### Brève description des dessins

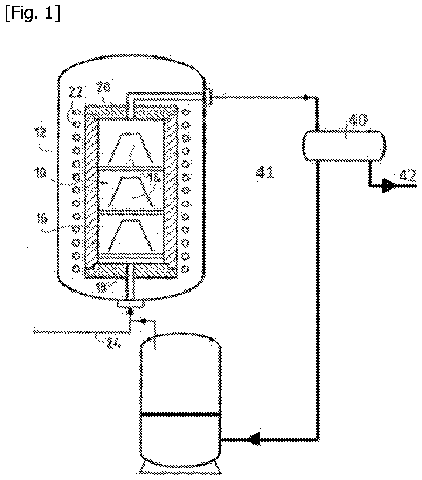

[Fig. 1] La figure 1 est une représentation schématique d'une installation permettant la mise en oeuvre d'un procédé de l'invention.

### Description des modes de réalisation

La figure 1 montre de manière schématique une installation d'infiltration chimique en phase gazeuse plus particulièrement destinée à la densification de substrats poreux par une matrice de carbone pyrolytique et permettant la réalisation d'un procédé tel que décrit ci-dessus.

Un four 10 logé dans une enveloppe 12 reçoit des substrats poreux à densifier 14, par exemple des préformes fibreuses de pièces à réaliser en matériau composite à matrice carbone.

Par exemple, les substrats à densifier peuvent être des préformes destinées à fabriquer des freins carbone.

Le four 10 est délimité par une paroi 16 formant induit, ou suscepteur, par exemple en graphite, ainsi que par un fond 18 et un couvercle 20. Le suscepteur 16 est couplé avec un inducteur 22, le chauffage du four étant assuré essentiellement par radiation du suscepteur chauffé par couplage inductif avec l'inducteur.

Une phase gazeuse réactive est introduite dans le four, par exemple par le fond 18 du four 10, par une conduite 24. La phase gazeuse réactive comporte un ou plusieurs précurseurs de carbone sous forme gazeuse. Comme détaillé ci-dessus, la phase gazeuse peut comporter un alcane linéaire ayant jusqu'à 4 atomes de carbone.

Le gaz effluent est extrait du four 10 à travers le couvercle 20, par une conduite 26 reliée à un dispositif de pompage 28 qui assure une circulation du gaz dans le four 10, en maintenant la pression réduite voulue à l'intérieur de ce dernier.

Une matrice de carbone pyrolytique est formée au sein de porosité des substrats par décomposition du ou des précurseur(s) gazeux contenus dans la phase réactive.

Des sous-produits de réactions sont également formés dans le four 10 et sont recueillis dans le gaz effluent avec une partie de la phase gazeuse réactive qui n'a pas réagi, ainsi que les produits obtenus lors de la décomposition du précurseur gazeux, notamment du dihydrogène H₂.

La figure 1 représente également un moyen de traitement 40 des gaz effluents recueillis à travers le couvercle 20. De tels moyens de traitement 40 permettent de séparer les hydrocarbures polyaromatiques des autres effluents gazeux.

Le moyen de traitement 40 par exemple une centrifugeuse est reliée à deux conduits de sortie 41 et 42. Les hydrocarbures polyaromatiques séparés des autres effluents gazeux par le moyen de traitement 40 sont recueillis via le conduit 41 vers un réservoir 30. Le conduit 41 peut être chauffé au moyen d'organes de chauffage non représentés en figure 1, pour éviter la condensation des hydrocarbures polyaromatiques qui pourrait occasionner des dépôts de goudrons dans les conduits.

Dans le mode de réalisation représenté, les hydrocarbures polyaromatiques 33 sont, après séparation des autres gaz effluents collectés dans un réservoir 30. Le réservoir 30 est en communication fluidique avec la conduite d'alimentation 24 du four 10.

Par exemple, les hydrocarbures polyaromatiques peuvent être dissous dans un solvant pour former une huile liquide. Comme précisé ci-dessus, le dibenzyl-toluène est un solvant préféré pour dissoudre les hydrocarbures polyaromatiques.

Le réservoir 30 est muni d'un système de chauffage non représenté en figure 1, de sorte que des vapeurs d'hydrocarbures polyaromatiques en équilibre avec les hydrocarbures polyaromatiques liquides 33 dans le réservoir 30 puissent s'échapper par une conduite 31 en tête du réservoir 30 et se mélanger à la phase gazeuse réactive dans la conduite d'alimentation 24, avant l'entrée dans le four 10 de la phase gazeuse réactive.

Pour enrichir la phase gazeuse en hydrocarbures polyaromatiques, le procédé peut comprendre une étape dans laquelle passer un gaz vecteur passe par un réservoir 30 contenant les hydrocarbures polyaromatiques. En adaptant les conditions de pression et de température dans le réservoir, c'est-à-dire en choisissant des conditions de température et de pression adéquate, un équilibre physique se créé et permet d'obtenir une migration des hydrocarbures polyaromatiques vers la phase gazeuse depuis la phase liquide. Cet équilibre est fonction de la température et de la pression du réservoir, ainsi que de la concentration de la phase liquide et de données propres aux hydrocarbures polyaromatiques comme par exemple la pression de vapeur des hydrocarbures polyaromatiques.

Il est donc possible de déterminer les conditions de températures et de pression dans le réacteur nécessaires pour obtenir une teneur déterminée en hydrocarbures polyaromatiques dans le gaz vecteur. En d'autres termes, piloter les conditions de pression et de température dans le réservoir 30 permet de piloter le flux d'hydrocarbures polyaromatiques qui chargent le gaz vecteur, et donc de piloter le flux d'hydrocarbures polyaromatiques introduits dans le four de densification.

Dans un mode de réalisation de l'invention, la pression du réservoir 30 peut être comprise entre 10 et 100 mbars, de préférence entre 10 et 50 mbars pour charger un gaz vecteur présent dans la partie supérieure du réservoir 30 en hydrocarbures polyaromatiques.

Dans un mode de réalisation de l'invention, la température du réservoir 30 peut être comprise entre 50 °C et 150 °C, de préférence entre 80 et 120 °C pour charger un gaz vecteur présent dans la partie supérieure du réservoir 30 en hydrocarbures polyaromatiques.

Dans un mode de réalisation du procédé, l'intégralité des conduits est chauffée à une température comprise entre 80°C et 100°C. Un tel chauffage des conduits permet d'éviter la recondensation des hydrocarbures polyaromatiques et ainsi de pour éviter que les hydrocarbures polyaromatiques ne forment des suies qui pourraient boucher les conduits.

Un système de pesée 32 est disposée pour le réservoir 30 afin de mesurer le débit d'hydrocarbures polyaromatiques sortant du réservoir 30 de sorte que l'on puisse contrôler la teneur en hydrocarbures polyaromatiques introduite dans le four de densification 10.

Le conduit de sortie 42 peut quant à lui être relié à d'autres moyens de recyclage non représentés pour recycler la partie des effluents gazeux ne comprenant pas les hydrocarbures polyaromatiques.

Par exemple, un procédé tel que décrit précédemment peut être réalisé dans une installation pour la densification gazeuse de substrats poreux par du carbone pyrolytique comprenant :
- un four de densification ;
- des moyens d'alimenter le four en une phase gazeuse réactive ;
- des moyens d'extraire du four les effluents gazeux issus de la phase gazeuse réactionnelle ;
- des moyens de séparation des différents composés des effluents gazeux et de récupération d'au moins un composé hydrocarbure polyaromatique;
- des moyens d'introduire une quantité choisie d'un hydrocarbure polyaromatique dans le four avec la phase gazeuse réactive.

Dans une telle installation, les moyens de séparation des différents composés des effluents gazeux peuvent être des moyens de centrifugation, de filtration mécanique, de précipitation par une action sur la température, de décantation ou une combinaison de ces méthodes des effluents gazeux.

De préférence, les moyens de séparation sont choisis parmi la filtration mécanique, la précipitation, la décantation ou une combinaison de ces méthodes.

Dans une telle installation, les moyens de séparations peuvent être connectés avec un réservoir de sorte que les hydrocarbures polyaromatiques, séparés des effluents gazeux, puissent être stockés.

Une installation permettant de réaliser le procédé peut comporter en outre des moyens de chauffage d'un tel réservoir.

En effet, le chauffage des composés hydrocarbures polyaromatiques permet de maintenir ces derniers sous la forme liquide et d'éviter qu'ils ne se solidifient, ce qui pourrait être préjudiciable aux conduits ou au réservoir, les composés hydrocarbures polyaromatiques pouvant solidifier sous forme de goudrons ou de suies capables de boucher les conduits.

Une installation permettant de réaliser le procédé peut comprendre en outre des moyens de chauffage de l'intégralité des conduits de l'installation.

Ce chauffage permet d'éviter une recondensation des hydrocarbures polyaromatiques dans les conduits lorsque ces derniers sont acheminés, par exemple entre les moyens de séparation et leur réintroduction dans le four, ou le cas échéant le réservoir. Eviter la recondensation des hydrocarbures polyaromatiques sous forme de suies permet d'augmenter la durée de vie de l'installation.

De préférence, une installation permettant de réaliser le procédé est exempte de tout appareil de transformation des hydrocarbures polyaromatiques car ces derniers n'ont pas besoin d'être transformer pour être réintroduits dans le four.

Par exemple, une telle installation peut comprendre en outre un moyen de mélanger la phase gazeuse réactive aux composés hydrocarbures polyaromatiques avant l'alimentation du four en phase gazeuse réactive.

Dans une installation permettant de réaliser le procédé, la phase gazeuse réactive acheminée vers le four de densification peut être mise en contact avec les vapeurs des composés hydrocarbures polyaromatiques issues du chauffage d'un réservoir les contenant.

Une installation permettant de réaliser le procédé peut également comporter des moyens pour ajuster le flux d'hydrocarbures polyaromatiques au cours de la densification des substrats poreux.

Par exemple, un réservoir contenant les composés hydrocarbures polyaromatiques peut être muni d'un système de pesée, de sorte que l'on puisse suivre l'évaporation des composés hydrocarbures polyaromatiques au cours du temps.

Un tel réservoir peut contenir les hydrocarbures polyaromatiques mis en solution dans une huile. Par exemple, le dibenzyl-toluène peut être utilisée comme solvant pour les hydrocarbures polyaromatiques.

Par exemple, la température de chauffe du réservoir peut être contrôlée pour obtenir le débit gazeux en composé hydrocarbure polyaromatique souhaité.

## Revendications

1. Procédé de densification d'un ou plusieurs substrats poreux par du carbone pyrolytique par infiltration chimique en phase vapeur comprenant au moins les étapes suivantes :
- l'admission en entrée du four de densification d'une phase gazeuse réactive comprenant au moins un précurseur de carbone pyrolytique ;
- la réaction d'au moins une fraction de la phase gazeuse réactive avec le ou les substrats poreux ;
- l'extraction en sortie du four de densification des effluents gazeux issus de la phase gazeuse réactive;
- la réintroduction avec la phase gazeuse réactive admise en entrée du four de densification d'au moins une fraction des effluents gazeux extraits en sortie du four ; **caractérisé en ce que** la fraction des effluents gazeux introduits avec la phase gazeuse réactive comprend au moins un composé hydrocarbure polyaromatique.

2. Procédé de densification selon la revendication 1, dans lequel le au moins un composé hydrocarbure polyaromatique est choisi parmi le napthalène, l'acénaphthylène, l'acénaphthène, le fluorène, le phénanthrène, l'anthracène, le fluoranthène, le pyrène, le dibenzyl-toluène et leurs mélanges.

3. Procédé de densification selon la revendication 1 ou 2, comprenant en outre une étape de séparation des composés des effluents gazeux extraits en sortie du four est réalisée par centrifugation, par filtration mécanique, par précipitation, par décantation ou par une combinaison de ces méthodes.

4. Procédé selon l'une quelconque des revendications 1 à 3, dans lequel la fraction des effluents gazeux est mélangée avec la phase gazeuse réactive avant son introduction dans le four de densification.

5. Procédé selon l'une quelconque des revendications 1 à 4, dans lequel le rapport massique entre les effluents gazeux réintroduits et la phase gazeuse réactive est compris entre 0,5 % et 5,0 %.

6. Procédé selon l'une quelconque des revendications 1 à 5, dans lequel la phase gazeuse réactive comprend du méthane, de l'éthane, du propane, du butane, un isomère du butane ou un mélange de ces composés.

7. Procédé selon l'une quelconque des revendications 1 à 6, dans lequel le ou les substrats poreux sont des préformes de freins carbone.

## Patentansprüche

1. Verfahren zum Verdichten von einem oder mehreren porösen Substraten mit pyrolytischem Kohlenstoff durch chemische Dampfinfiltration, umfassend mindestens die folgenden Schritte:
- Einlassen einer reaktiven Gasphase, die mindestens einen pyrolytischen Kohlenstoffvorläufer umfasst, an dem Eingang des Verdichtungsofens,
- Reagieren von mindestens einem Teil der reaktiven Gasphase mit dem oder den porösen Substrat(en),
- Absaugen von gasförmigen Abströmen aus der reaktiven Gasphase an dem Ausgang des Verdichtungsofens,
- Wiedereinführen von mindestens einem Teil der an dem Ausgang des Ofens abgesaugten gasförmigen Abströme mit der an dem Eingang des Verdichtungsofens eingelassenen reaktiven Gasphase,
**dadurch gekennzeichnet, dass** der Teil der mit der reaktiven Gasphase eingeführten gasförmigen Abströme mindestens eine polyaromatische Kohlenwasserstoffverbindung umfasst.

2. Verfahren zum Verdichten nach Anspruch 1, wobei die mindestens eine polyaromatische Kohlenwasserstoffverbindung aus Naphthalin, Acenaphthylen, Acenaphthen, Fluoren, Phenanthren, Anthracen, Fluoranthen, Pyren, Dibenzyltoluol und Mischungen davon ausgewählt ist.

3. Verfahren zum Verdichten nach Anspruch 1 oder 2, ferner umfassend einen Schritt der Abtrennung der Verbindungen aus den an dem Ausgang des Ofens abgesaugten gasförmigen Abströmen, der durch Zentrifugieren, durch mechanische Filtration, durch Fällung, durch Dekantieren oder durch eine Kombination dieser Vorgänge umgesetzt wird.

4. Verfahren nach einem der Ansprüche 1 bis 3, wobei der Teil der gasförmigen Abströme vor seiner Einleitung in den Verdichtungsofen mit der reaktiven Gasphase vermischt wird.

5. Verfahren nach einem der Ansprüche 1 bis 4, wobei das Massenverhältnis zwischen den wiedereingeführten gasförmigen Abströmen und der reaktiven Gasphase zwischen 0,5 % und 5,0 % beträgt.

6. Verfahren nach einem der Ansprüche 1 bis 5, wobei die reaktive Gasphase Methan, Ethan, Propan, Butan, ein Isomer von Butan oder eine Mischung dieser Verbindungen umfasst.

7. Verfahren nach einem der Ansprüche 1 bis 6, wobei das oder die poröse(n) Substrat(e) Vorformen von Carbon-Bremsen sind.

## Claims

1. A method for densifying one or more porous substrates with pyrolytic carbon by chemical vapour infiltration, comprising at least the following steps:
- admitting, at the inlet of the densification furnace, a reactive gaseous phase comprising at least one pyrolytic carbon precursor;
- reacting at least a fraction of the reactive gaseous phase with the porous substrate or substrates;
- extracting, at the outlet of the densification furnace, gaseous effluents originating from the reactive gaseous phase;
- reintroducing, with the reactive gaseous phase admitted at the inlet of the densification furnace, at least a fraction of the gaseous effluents extracted at the outlet of the furnace;
**characterised in that** the fraction of the gaseous effluents introduced with the reactive gaseous phase comprises at least one polyaromatic hydrocarbon compound.

2. The densification method according to claim 1, in which the at least one polyaromatic hydrocarbon compound is chosen from naphthalene, acenaphthylene, acenaphthene, fluorene, phenanthrene, anthracene, fluoranthene, pyrene, dibenzyl toluene and mixtures thereof.

3. The densification method according to claim 1 or 2, further comprising a step of separating the compounds from the gaseous effluents extracted at the outlet of the furnace, which is carried out by centrifugation, mechanical filtration, precipitation, decantation or a combination of these methods.

4. The method according to any one of claims 1 to 3, in which the fraction of the gaseous effluents is mixed with the reactive gaseous phase before it is introduced into the densification furnace.

5. The method according to any one of claims 1 to 4, in which the weight ratio between the reintroduced gaseous effluents and the reactive gaseous phase is between 0.5% and 5.0%.

6. The method according to any one of claims 1 to 5, in which the reactive gaseous phase comprises methane, ethane, propane, butane, a butane isomer or a mixture of these compounds.

7. The method according to any one of claims 1 to 6, in which the porous substrate or substrates are carbon brake preforms.
